# EUROPEAN PATENT APPLICATION

(11) **EP 4 712 144 A1**
(43) Date of publication of application: **18.03.2026**
(21) Application number: 24807146.6
(22) Date of filing: 10.05.2024
(51) Int. Cl.: H01L 33/32, F21V 9/35, H01L 21/3065, H01L 33/04, H01L 33/22

(54) **METHOD FOR MANUFACTURING PHOTONIC CRYSTAL GALLIUM NITRIDE LIGHT-EMITTING ELEMENT, AND LIGHTING DEVICE**

(30) Priority: 12.05.2023 JP 2023079463; 10.07.2023 JP 2023112958
(71) Applicant: Nitride Semiconductors Co., Ltd., Naruto-shi, Tokushima 771-0360 (JP); Nikon Corporation, Tokyo 140-8601 (JP)
(72) Inventor: MURAMOTO, Yoshihiko, Naruto-shi, Tokushima 771-0360 (JP); NISHINE, Tatsuro, Tokyo 140-8601 (JP)
(74) Representative: Osha BWB
(86) International application number: PCT/JP2024/017392
(87) International publication number: WO 2024/237194

(57) **Abstract**

Provided is a method for obtaining a photonic crystal GaN light-emitting element by efficiently forming a photonic crystal on a GaN layer that constitutes a light-emitting element. This method comprises: a step in which an n-type GaN layer (12), an MQW layer (14), and a p-type GaN layer (16) are epitaxially grown in sequence on a sapphire substrate (10) to form an epitaxial structure; a step in which a p-type electrode, a metal substrate, and a support substrate are formed on the p-type GaN layer (16); a step in which the top and bottom of the epitaxial structure are inverted; a step in which the sapphire substrate (10) is peeled to expose the n-type GaN layer (12) at a surface; a step in which a photonic crystal is formed on the surface of the n-type GaN layer (12) exposed at the surface by electron beam drawing and inductively coupled plasma reactive ion etching; and a step in which an n-electrode (24) is formed.

## Description

### TECHNICAL FIELD

The present invention relates to a method for manufacturing a photonic crystal gallium nitride light-emitting element.

### BACKGROUND

In order to narrow the radiation angle of light emitted from a light-emitting element (LED) chip using gallium nitride (GaN), studies have been conducted on mounting a lens on the LED device to collect light.

However, in a case where a lens is mounted, if the radiation pattern is changed even slightly, it is necessary to change the mold, which increases cost. In addition, in a case where ultraviolet rays or deep ultraviolet rays are emitted, a quartz lens is used in consideration of lens absorption, which makes the lens expensive.

Therefore, as a method for narrowing the radiation pattern by condensing light without mounting a lens on an LED device, studies have been conducted on forming a photonic crystal on a surface of an LED chip with holes on the order of several hundred nanometers at a pitch of several hundred nanometers.

Patent Document 1 describes an invention related to a gallium nitride-based photonic crystal and a method for producing the same. That is, in order to provide a gallium nitride-based semiconductor element, a gallium nitride-based semiconductor substrate, and a gallium nitride-based photonic crystal with high performance at a high yield by obtaining a nitride semiconductor having good crystallinity in which the dislocation density is reduced in a wide region in epitaxial growth, it is described that the method includes: forming a gallium nitride-based semiconductor layer on a substrate; arranging and forming a plurality of trenches in the gallium nitride-based semiconductor layer; and performing a heat treatment in an atmosphere containing nitrogen to deform two or more trenches adjacent to each other among the plurality of trenches and form a continuous cavity inside the gallium nitride-based semiconductor layer corresponding to a position of the deformed trenches, and forming a gallium nitride-based semiconductor element on the gallium nitride-based semiconductor layer with the cavity therein.

In addition, in order to provide a photonic crystal light-emitting diode that is less likely to deteriorate over a long period of time, and has high energy efficiency and high luminous efficiency, Patent Document 2 discloses a photonic crystal light-emitting diode having a structure in which three layers, a first semiconductor layer, an active layer, and a second semiconductor layer, are stacked in this order, with a first electrode electrically connected to the first semiconductor layer and a second electrode electrically connected to the second semiconductor layer, in which holes penetrating at least the first semiconductor layer and the active layer among the three layers are arranged two-dimensionally and periodically so as to form a photonic crystal structure, and the first electrode covers a region of the first semiconductor layer excluding the holes and a first non-current injection region surrounding the holes.

### CITATION LIST

### PATENT LITERATURE

Patent Document 1: JP 2004-111766 A
Patent Document 2: JP 2011-54828 A

### SUMMARY

### TECHNICAL PROBLEM

However, in a case where a light-emitting element such as an LED is made of gallium nitride (GaN), the technology for forming a photonic crystal on a GaN layer has not yet been established.

An object of the present invention is to provide a method for obtaining a photonic crystal GaN light-emitting element by efficiently forming a photonic crystal on a GaN layer constituting the light-emitting element, and a lighting device.

### SOLUTION TO PROBLEM

The present invention provides a method for manufacturing a photonic crystal gallium nitride light-emitting element, the method including: forming an epitaxial structure by epitaxially growing an n-type gallium nitride layer, a multiple quantum well layer, and a p-type gallium nitride layer sequentially on a sapphire substrate; forming a p-type electrode on the p-type gallium nitride layer; forming a metal substrate and a support substrate on the p-type electrode; inverting the epitaxial structure upside down so that the support substrate is located at the bottom and the sapphire substrate is located at the top; exposing a surface of the n-type gallium nitride layer by peeling off the sapphire substrate located at the top by the inversion; adjusting a film thickness by etching the exposed surface of the n-type gallium nitride layer; forming a photonic crystal on the etched surface of the n-type gallium nitride layer using electron beam lithography and inductively coupled plasma reactive ion etching; forming an n-type electrode on the n-type gallium nitride layer; and peeling off the support substrate.

In one embodiment of the present invention, the step of forming the photonic crystal includes: performing a hydrophobizing treatment on the surface of the n-type gallium nitride layer; applying a resist to the surface of the n-type gallium nitride layer; irradiating the resist with an electron beam for lithography; and removing the resist using chlorine gas by inductively coupled plasma reactive ion etching.

In another embodiment of the present invention, the method further includes, before growing the n-type gallium nitride layer on the sapphire substrate, growing a buffer layer and an undoped gallium nitride layer sequentially on the sapphire substrate.

In still another embodiment of the present invention, the photonic crystal gallium nitride light-emitting element has an emission wavelength of 380 nm to 390 nm.

In addition, the present invention provides a lighting device including: the photonic crystal gallium nitride light-emitting element manufactured by the above-described method; and an illumination optical system that illuminates an object with light from the photonic crystal gallium nitride light-emitting element.

### ADVANTAGEOUS EFFECTS OF INVENTION

According to the present invention, a photonic crystal can be reliably formed on a GaN layer constituting a gallium nitride (GaN) light-emitting element. As a result, the radiation pattern of light emitted from the light-emitting element can be narrowed. In addition, the light emission efficiency of the gallium nitride light-emitting element can be increased.

### BRIEF DESCRIPTION OF DRAWINGS

FIG. 1A is a schematic cross-sectional view (part 1) showing a manufacturing method according to an embodiment.
FIG. 1B is a schematic cross-sectional view (part 2) showing the manufacturing method according to the embodiment.
FIG. 1C is a schematic cross-sectional view (part 3) showing the manufacturing method according to the embodiment.
FIG. 1D is a schematic cross-sectional view (part 4) showing the manufacturing method according to the embodiment.
FIG. 1E is a schematic cross-sectional view (part 5) showing the manufacturing method according to the embodiment.
FIG. 1F is a schematic cross-sectional view (part 6) showing the manufacturing method according to the embodiment.
FIG. 1G is a schematic cross-sectional view (part 7) showing the manufacturing method according to the embodiment.
FIG. 1H is a schematic cross-sectional view (part 8) showing the manufacturing method according to the embodiment.
FIG. 1I is a schematic cross-sectional view (part 9) showing the manufacturing method according to the embodiment.
FIG. 1J is a schematic cross-sectional view (part 10) showing the manufacturing method according to the embodiment.
FIG. 2 is a diagram showing a configuration of a lighting device and an exposure apparatus according to the embodiment.
FIG. 3 is a diagram showing a configuration of a light source unit.
FIG. 4 is an SEM image after electron beam lithography according to the embodiment.
FIG. 5 shows SEM images after inductively coupled plasma reactive ion etching according to the embodiment, in which FIG. 5(a) is an SEM image of inner diameters of holes, and FIG. 5(b) is an SEM image of outer diameters of holes.
FIG. 6 is a cross-sectional SEM image of a hole according to the embodiment.
FIG. 7 is a perspective view of a GaN wafer according to the embodiment.
FIG. 8 is a partially enlarged view of FIG. 7.
FIG. 9 is a table showing results of measuring reference chips using probes.
FIG. 10 is a table showing results of measuring LED chips (PhC-formed chips) using probes according to the embodiment.
FIG. 11 is a table showing results of measuring references and PhC-formed chips using an integrating sphere.
FIG. 12 is a diagram showing emission spectra of references and PhC-formed chips.
FIG. 13 is a diagram showing I-V characteristics of references and PhC-formed chips.
FIG. 14 is a diagram showing I-L characteristics of references and PhC-formed chips.
FIG. 15 is a diagram showing results of measuring radiation pattern characteristics of references.
FIG. 16 is a diagram showing results of measuring radiation pattern characteristics of PhC-formed chips.

### DESCRIPTION OF EMBODIMENTS

Hereinafter, an embodiment of the present invention will be described with reference to the drawings.

Taking into account that the etching rate of the GaN layer, which is etched by electron beam (EB) lithograph and inductively coupled plasma reactive ion etching to form a photonic crystal on the GaN layer constituting the GaN light-emitting element, varies greatly depending on the differences in structure and crystallinity of the substrate and the GaN layer, the basic principle of the present embodiment is to grow a GaN layer on a sapphire substrate, rather than growing a GaN layer on an Si substrate or the like, and to form a photonic crystal by performing electron beam (EB) lithograph and inductively coupled plasma reactive ion etching on the GaN layer grown as described above.

The inventors of the present application have found that, when compared to the GaN layer grown on the Si substrate, the GaN layer grown on the sapphire substrate has a significantly higher etching rate when etched by electron beam (EB) lithograph and inductively coupled plasma reactive ion etching, forming photonic crystal with holes formed in an extremely efficient manner at desired intervals and with desired diameters on the surface of the GaN layer.

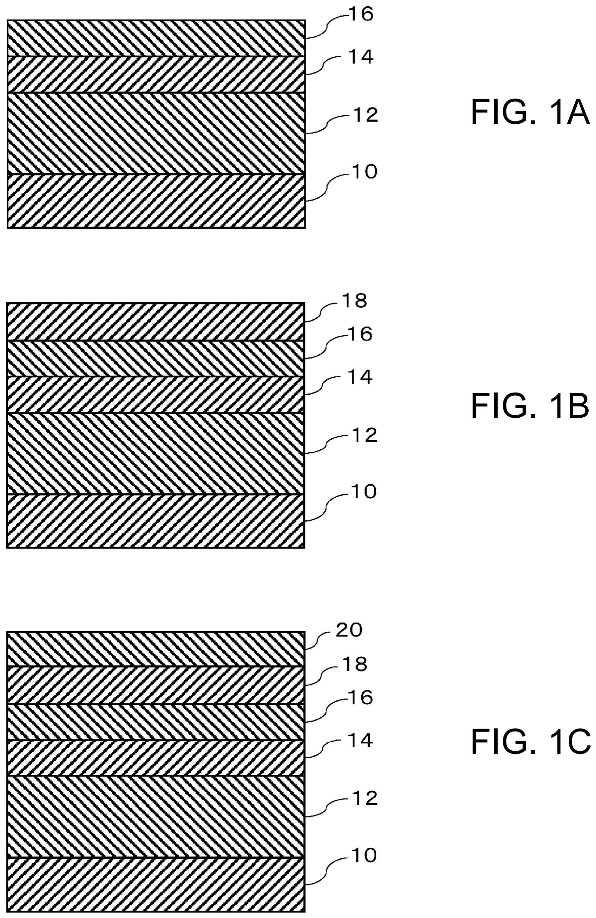

FIGS. 1A to 1J are cross-sectional views schematically showing a method for manufacturing a photonic crystal GaN light-emitting element (LED) in the present embodiment.

As shown in FIG. 1A, a low-temperature buffer layer (not shown) and an undoped GaN (u-GaN) layer (not shown) are stacked on a sapphire substrate 10 using a metal organic chemical vapor deposition (MOCVD) apparatus, and an n-GaN layer (n-type GaN layer) 12, a multiple quantum well (MQW) layer 14, and a p-GaN layer (p-type GaN layer) 16 are sequentially stacked thereon to grow an epitaxial structure emitting light at 385 nm (380 to 390 nm).

Here, the n-GaN layer 12 is more specifically formed of an (AlInGaN)/(InGaN;Si) n-SLS (super-lattice structure) layer and a (GaN;Si) contact layer. Here, for example, (GaN;Si) indicates GaN doped with Si.

The multiple quantum well (MQW) layer 14 is formed of an MQW layer of (InGaN/AlGaN).

In addition, the p-GaN layer 16 is more specifically formed of a p-GaN(GaN;Mg) contact layer and an (AlGaN;Mg/GaN;Mg) p-SLS (super-lattice structure) layer.

The "GaN layer" in the present embodiment does not necessarily mean a single layer composed of GaN, but means a single layer or multiple layers composed of AlInGaN, InGaN, AlGaN, or the like containing GaN. In short, it means a single layer or multiple layers containing GaN as a main component.

Note that, although the emission wavelength of the epitaxial layer in the present embodiment is 385 nm, the emission wavelength of the epitaxial layer may be longer than 385 nm. In this case, the basic epitaxial structure is the same. However, from the relationship with bandgap energy, the (InGaN/AlInGaN) MQW light-emitting layer 14 has a higher A1 content and a lower In content in a case where the emission wavelength of the epitaxial layer is 385 nm than in a case where the emission wavelength of the epitaxial layer is longer than 385 nm.

Next, as shown in FIG. 1B, a p-electrode (p-type electrode: ITO or the like) and a metal reflective film (Ag or the like) are deposited on the epitaxial structure layer that emits light at 385 nm. In FIG. 1B, the p-electrode and the metal reflective film are collectively shown as a p-electrode and reflection film 18.

Next, as shown in FIG. 1C, a metal substrate (CuW, CuMo, or the like) 20 is bonded onto the p-electrode and metal reflective film 18.

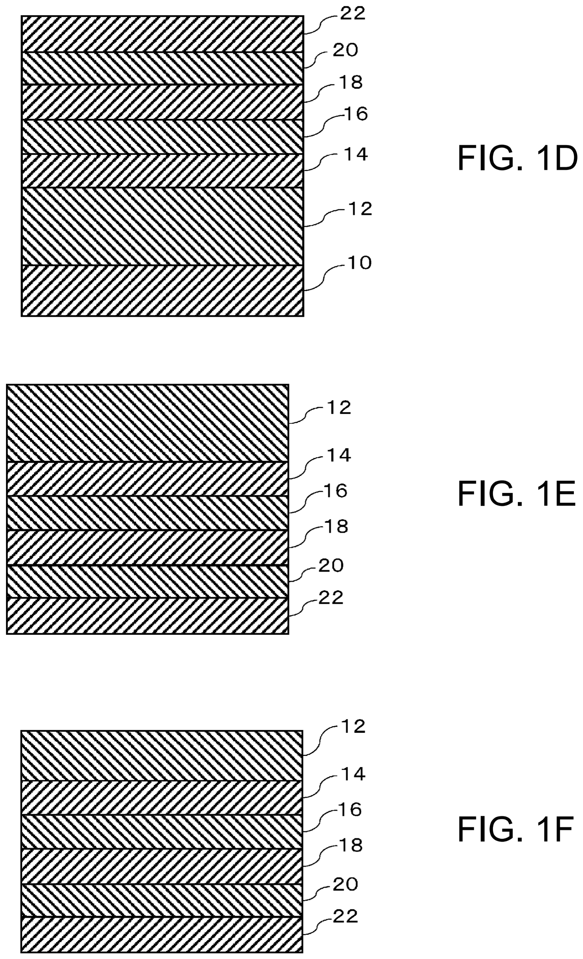

Next, as shown in FIG. 1D, a support substrate (sapphire, Si substrate, or the like) 22 is bonded onto the metal substrate 20. The stacked structure shown in FIG. 1D includes in the following order from the bottom:
sapphire substrate 10/ n-GaN layer 12/ MQW layer 14/ p-GaN layer 16/ p-electrode and reflection film 18/ metal substrate 20/ support substrate 22.

Next, as shown in FIG. 1E, the epitaxial structure of FIG. 1D is inverted upside down by 180° so that the sapphire substrate 10 is located at the top, and the sapphire substrate 10 is peeled off (lifted off) using a laser to expose a surface of the n-GaN layer 12. That is, the stacked structure obtained by vertically inverting the epitaxial structure of FIG. 1D by 180° includes in the following order from the bottom:
support substrate 22/ metal substrate 20/ p-electrode and reflection film 18/ p-GaN layer 16/ MQW layer 14/ n-GaN layer 12/ sapphire substrate 10.

Among them, the uppermost sapphire substrate 10 (and the buffer layer) is peeled off (lifted off) to expose the uppermost surface of the n-GaN layer 12.

Next, as shown in FIG. 1F, the surface of the n-GaN layer 12 is etched. Specifically, the total film thickness of the epitaxial structure is adjusted to 1050 um by dry etching. Note that the total film thickness of the epitaxial structure is not limited thereto, and can be optimized by the emission wavelength.

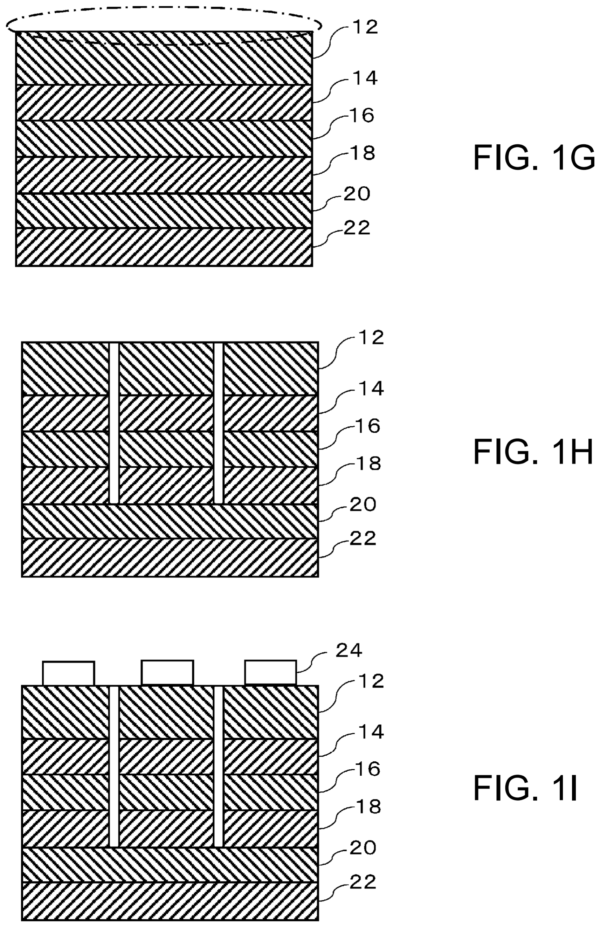

Next, as shown in a one-dot chain line region in FIG. 1G, a photonic crystal (PhC) is formed on the surface of the n-GaN layer 12 whose film thickness has been adjusted by dry etching. This will be further described later.

Next, as shown in FIG. 1H, trenches are formed from the surface of the n-GaN layer 12 until reaching the metal substrate 20 to divide the epitaxial structure.

Next, as shown in FIG. 1I, an n-electrode (n-type electrode) 24 is formed in each divided region on the n-GaN layer 12.

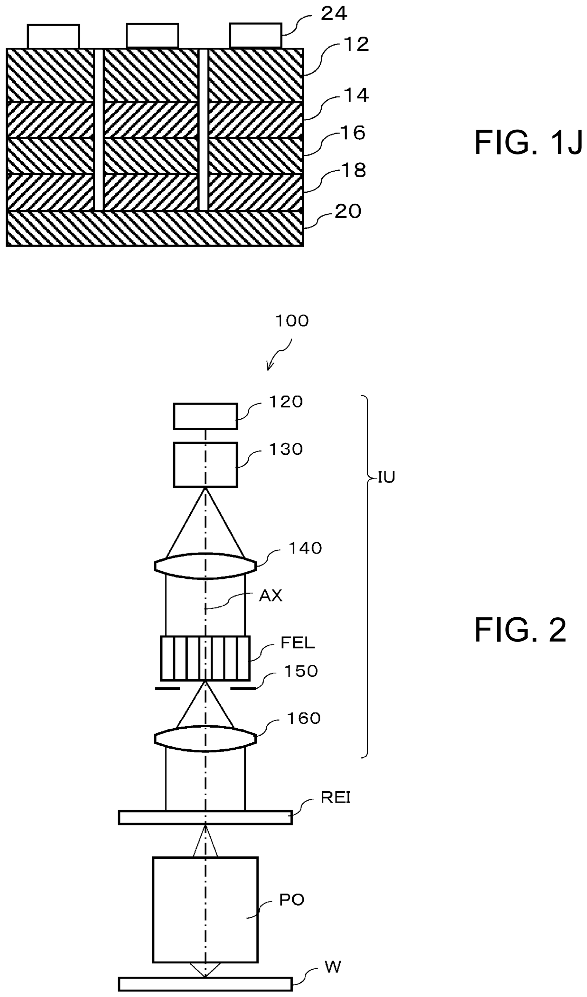

Lastly, as shown in FIG. 1J, the support substrate 22 is peeled off, and diced to manufacture LED chips (V-chip structure LED chips: vertical-type LED chips in which electrodes are arranged in a vertical structure).

Here, the method for manufacturing the photonic crystal shown in FIG. 1G will be described in more detail.

The photonic crystal (PhC) is formed by developing a pattern on a resist by electron beam (EB) lithography, followed by inductively coupled plasma reactive ion etching. Therefore, prior to forming the photonic crystal, it is necessary to set conditions for the EB lithography and etching conditions for the inductively coupled plasma reactive ion etching.

### <Etching Conditions>

The etching rate may vary depending on the difference in substrates stacked on the Si substrate, the sapphire substrate, or the like, and the difference in the structure and crystallinity of GaN.

Therefore, to determine etching rate, a GaN wafer having an emission wavelength of 385 nm and grown on the sapphire substrate was rinsed, and then dried at 120°C for 2 minutes. Thereafter, the surface of the GaN wafer was treated to make it hydrophobic (HMDS treatment), and then a UV resist was applied to the surface of the GaN wafer at a thickness of 950 nm using a spin coater, followed by pre-baking at 90°C for 90 seconds.

Next, a pattern of 100 um × 100 um was formed at 150 mJ/cm² using a high-speed maskless exposure apparatus, and was developed by post-baking at 110°C for 90 seconds.

Using the GaN wafer on which the UV resist was formed, etching was performed for 10 minutes with chlorine gas (30 sccm) using an inductively coupled plasma reactive ion etching apparatus. As a result of measuring a depth using a UV probe type step profiler, it was confirmed that the depth was 789.05 nm. The etching rate was 78.9 nm/min.

On the other hand, as a result of confirming an etching rate in a similar manner using a GaN wafer having an emission wavelength of 385 nm and grown on an Si substrate, the etching rate was 16 nm/min. That is,
the GaN layer grown on the sapphire substrate: etching rate = 78.9 nm/min; and
the GaN layer grown on the Si substrate: etching rate = 16 nm/min.

However, it has been confirmed that, while it is relatively difficult to form a photonic crystal in the GaN layer using the Si substrate, a photonic crystal can be formed efficiently at a remarkably high etching rate in the GaN layer grown on the sapphire substrate; that is, the GaN layer on the metal substrate 20 as a treatment target after growing the GaN layer on the sapphire substrate 10 first and inverting the stack upside down and removing the sapphire substrate 10, by etching the GaN layer by inductively coupled plasma reactive ion etching as in the present embodiment.

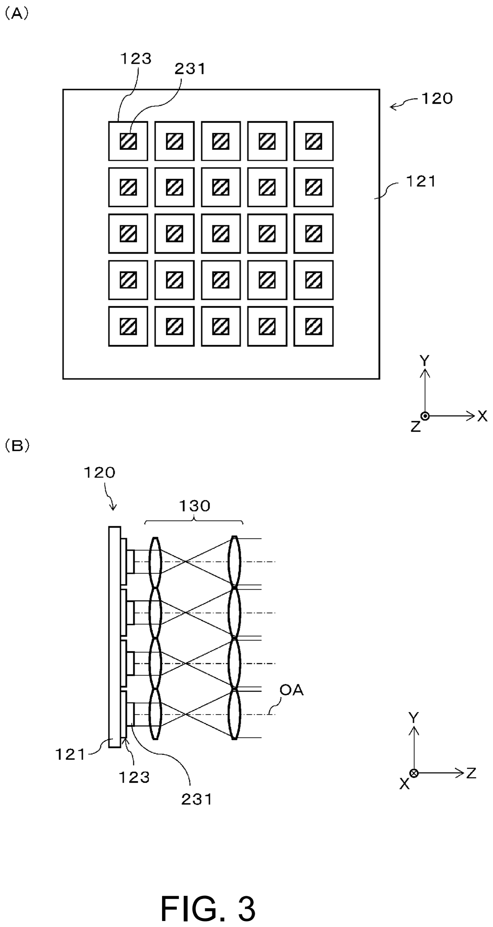

Next, a lighting device including a GaN light-emitting element manufactured by the manufacturing method according to the above-described embodiment and an exposure apparatus including the lighting device will be described with reference to FIGS. 2 and 3.

FIG. 2 is a diagram schematically showing a configuration of an exposure apparatus including a lighting device IU using a GaN light-emitting element manufactured by the manufacturing method according to the above-described embodiment as a light source. FIG. 3(A) is a plan view schematically showing a configuration of a light source unit 120 that supplies exposure light to the lighting device IU, and FIG. 3(B) is a view schematically showing an internal configuration of the light source unit 120 and an output optical system 130.

As shown in FIG. 2, the lighting device IU includes a first condensing optical system 140 that condenses exposure light from the light source unit 120 via the output optical system 130, a fly-eye lens FEL on which the exposure light from the first condensing optical system 140 is incident, and a second condensing optical system 160 that condenses the exposure light from the fly-eye lens FEL and illuminates a reticle REI as an irradiated surface.

The exposure apparatus includes a lighting device IU and a projection optical system PO that forms a pattern image on the reticle illuminated by the lighting device IU onto a wafer as an exposed substrate.

Next, the light source unit 120 and the output optical system 130 will be described with reference to FIG. 3.

As shown in FIG. 3(A), the light source unit 120 includes, for example, a plurality of (5×5 in FIG. 3(A)) light-emitting diode (LED) chips 123 arranged on a substrate 121. These LED chips are GaN light-emitting elements manufactured by the manufacturing method according to the above-described embodiment. Note that the number of LED chips 123 may be appropriately changed as necessary. Each of the plurality of LED chips 123 has a light-emitting unit 231, and a peak wavelength of light emitted from the light-emitting unit 231 is in a range of 380 to 390 nm. That is, the light-emitting unit 231 is an ultraviolet LED (UVLED). More preferably, the peak wavelength of the light emitted from the light-emitting unit 231 is 385 nm. The light-emitting surface of the light-emitting unit 231 may have a square shape, a rectangular shape, or any other polygonal shape such as a hexagonal shape. Note that the LED chips 123 may be arranged on, for example, a heat sink instead of the substrate.

The configurations of the light source unit 120 and the output optical system 130 will be described with reference to FIG. 3(B). In FIG. 3(B), two directions in which the LED chips 123 are arranged are defined as an X direction and a Y direction. The X direction and the Y direction are orthogonal to each other. A direction orthogonal to the X direction and the Y direction is defined as a Z direction. The Z direction substantially coincides with a traveling direction of light emitted from the light-emitting unit 231. In FIG. 3(B), for the sake of clarity in the drawing, only four LED chips 123 arranged in a row along the Y direction are shown.

As shown in FIG. 3(B), the output optical system 130 includes a plurality of magnifying optical systems for forming magnified images of the light-emitting units 231 of the respective LED chips 123. The magnifying optical systems are arranged so as to correspond to the arrangement of the LED chips 123, and are double-telecentric optical systems that project the respective light-emitting units 231 in an enlarged manner at an enlargement magnification. Note that, although it is shown in FIG. 3(B) that each magnifying optical system of the output optical system 130 is constituted by two positive lenses, the number of lenses constituting the magnifying optical system is not limited to two. In addition, the magnifying optical system may also be constituted by a catoptric system or a catadioptric system. Then, the output optical system 130 may include equal magnification optical systems and reduction optical systems instead of or in addition to the magnifying optical systems.

In the embodiment shown in FIGS. 2 and 3, each magnifying optical system of the output optical system 130 forms a magnified image of the light-emitting unit 231 in the vicinity of the last optical member of the output optical system 130. As a result, a plurality of closely arranged light source images are positioned in the vicinity of the last optical member of the output optical system 130.

Returning to FIG. 2, each component of the lighting device IU will be described.

The first condensing optical system 140 is disposed such that the front focal point is located at or near the position of the light source image formed by the light source unit 120 and the output optical system 130, and performs Köhler illumination on the incident surface of the fly-eye lens FEL.

The fly-eye lens FEL is configured by, for example, arranging a plurality of lens elements having positive refractive power densely in rows and columns such that their optical axes are parallel to a reference optical axis AX. Each lens element constituting the fly-eye lens FEL has a rectangular cross section similar to the shape of the illumination field to be formed on the reticle REI (eventually, the shape of the exposure region to be formed on the wafer W).

Therefore, the light flux incident on the fly-eye lens FEL is wavefront-split by the plurality of lens elements, and one light source image is formed at or near the rear focal plane (emission surface) of each lens element. That is, a substantial surface light source including a plurality of light source images; that is, a secondary light source, is formed on or near the rear focal plane (emission surface) of the fly-eye lens FEL.

Here, focusing on one lens element of the fly-eye lens FEL, a plurality of light source images formed by the light source unit 120 and the output optical system 130 are formed on or near the rear focal plane (emission surface) of this one lens element, and the plurality of light source images are distributed in a region having a shape similar to a region where the plurality of LED chips 123 are arranged. Therefore, the region where the plurality of LED chips 123 are arranged and the cross section of each lens element of the fly-eye lens FEL may have similar shapes.

The light flux from the secondary light source formed on or near the rear focal plane (emission surface) of the fly-eye lens FEL is incident on an aperture stop 150 disposed near the rear focal plane. In the present embodiment, the rear focal plane (emission surface) of the fly-eye lens FEL and the LED chip arrangement surface of the light source unit 120 are optically conjugate.

The aperture stop 150 is disposed at a position optically substantially conjugate with the entrance pupil plane of the projection optical system PO, and has a variable aperture for defining a range contributing to the illumination of the secondary light source. After being subjected to a light condensing action of the second condensing optical system 160, exposure light from the secondary light source via the aperture stop 150 illuminates the reticle REI on which the predetermined pattern is formed in a superimposed manner.

Then, the exposure light from the reticle REI illuminated by the lighting device IU (the exposure light passing through the pattern located in the illumination field on the reticle REI) is incident on the projection optical system PO, and forms a pattern image of the reticle REI on the wafer W as an exposed substrate. As a result, the pattern of the reticle REI is exposed to the exposure region of the wafer W. Note that the projection magnification of the projection optical system PO may be a reduction magnification, an enlargement magnification, or an equal magnification. Further, the projection optical system PO may be a dioptric system, a catoptric system, or a catadioptric system.

### EXAMPLES

A GaN wafer having an emission wavelength of 385 nm was rinsed, and then dried at 120°C for 2 minutes. Thereafter, the surface of the wafer was treated to make it hydrophobic (HMDS treatment), and then an EB resist was applied to the surface of the wafer at a thickness of 500 nm using a spin coater, followed by pre-baking at 180°C for 3 minutes.

Next, using a high-speed and high-accuracy electron beam lithography apparatus, exposure was performed under nine conditions while changing the exposure amount (dose amount (µC/cm²)). The dose amounts (µC/cm²) under the nine conditions were 150, 160, 170, 180, 190, 200, 210, 220, and 230, respectively.

After development, a hole diameter was confirmed using a scanning electron microscope (SEM). As a result, the correspondence relationship between the exposure amount (dose amount) and the hole diameter was found to be as follows:
Dose amount: 150 → 293.3 nm;
Dose amount: 160 → 296.00 nm;
Dose amount: 170 → 309.33 nm;
Dose amount: 180 → 314.67 nm;
Dose amount: 190 → 320.00 nm;
Dose amount: 200 → 325.33 nm;
Dose amount: 210 → 330.67 nm;
Dose amount: 220 → 338.67 nm; and
Dose amount: 230 → 352.00 nm. It was confirmed that there was a positive correlation between the exposure amount and the hole diameter.

From the above-described results under the EB lithography conditions, exposure was performed at 140 µC/cm² using the high-speed and high-accuracy electron beam lithography apparatus, and hole diameters were confirmed by the SEM after development.

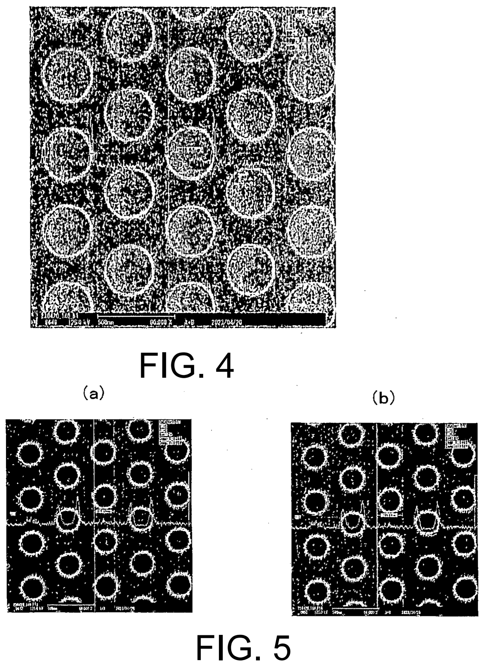

FIG. 4 shows an SEM image after development. It was confirmed that the hole diameters were formed in the range of 286 to 292 nm.

Next, etching was performed with chlorine gas (30 sccm) using an inductively coupled plasma reactive ion etching apparatus, and hole diameters were confirmed by the SEM after the EB resist was peeled off. As a result, it was confirmed that the outer diameters were in the range of 262 to 269 nm, the inner diameters were 213 to 220 nm, and the taper angles were sufficiently suppressed to 70 to 80 degrees.

FIG. 5 shows SEM images after etching using an inductively coupled plasma reactive ion etching apparatus. FIG. 5(a) is an SEM image of inner diameters, and FIG. 5(b) is an SEM image of outer diameters. It was confirmed that holes were formed on the order of several hundred nanometers at a pitch of several hundred nanometers on the surface of the GaN wafer, forming a photonic crystal.

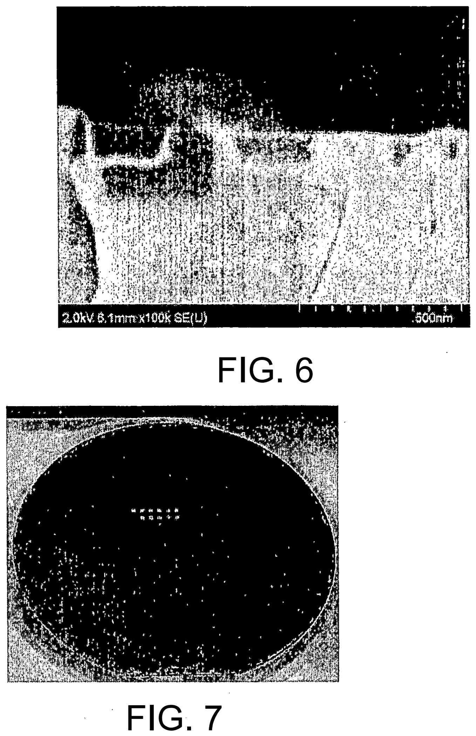

FIG. 6 shows an SEM image of a cross section of a GaN wafer after being etched by an inductively coupled plasma reactive ion etching apparatus. The taper angles of the holes constituting the photonic crystal are in the range of 70 to 80 degrees. In order to narrow the radiation angle of the light emitted from the LED chip, it is desirable that the holes constituting the photonic crystal are not tapered; that is, the taper angle is 90 degrees. In the present embodiment, the taper angles are in the range of 70 to 80 degrees, obtaining a good result.

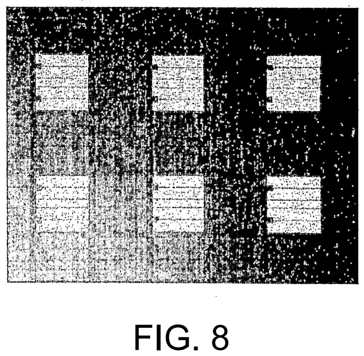

FIG. 7 shows a perspective view of an appearance of a GaN wafer on which a photonic crystal is formed. FIG. 8 is a partially enlarged view thereof. It was confirmed that illumination light (fluorescent light in a room and halogen light from a microscope) illuminating the GaN wafer was confined in an area where the photonic crystal was formed, making that area brighter than the other areas.

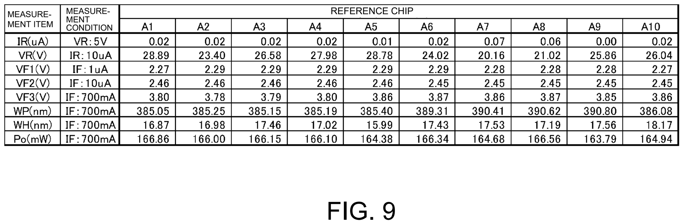

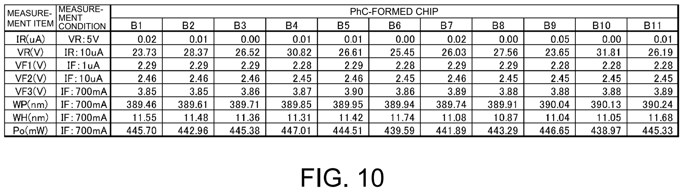

FIGS. 9 and 10 show results of measuring electrical characteristics of reference chips and LED chips (PhC-formed chips) according to the present embodiment, respectively, using a prober. Here, the reference chips shown in FIG. 9 are LED chips in which photonic crystals are not formed on GaN layers, and are a total of 10 LED chips A1 to A10 located at different positions on the wafer. In addition, the LED chips according to the present embodiment shown in FIG. 10 are LED chips in which photonic crystals (PhC) are formed on GaN layers, and are a total of 11 LED chips B1 to B11 located at different positions on the wafer. Both the reference chips and the PhC-formed chips exhibited good electrical characteristics, but, for example, the reference chip A1 and the PhC chip were compared in terms of half-value width (WH) and optical output (Po) as follows.

### <Reference Chip A1>

Half-value width WH = 16.87 (nm)
Optical output Po = 166.86 (mW)

### <PhC-Formed Chip B1>

Half-value width WH = 11.55 (nm)
Optical output Po = 445.70 (mW)

Compared to the reference chip, the LED chips according to the present embodiment exhibited significantly decreased half-value widths and significantly increased optical outputs. On average, the half-value width WH decreased by approximately 5.9 nm, and the optical output Po increased by a factor of approximately 2.68 times.

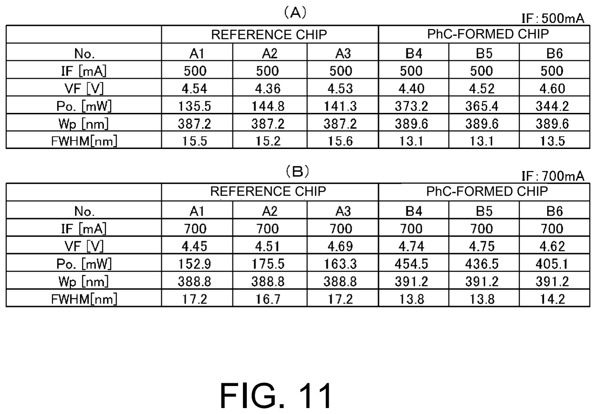

FIG. 11 shows results of measuring reference chips and LED chips (PhC-formed chips) according to the present embodiment using an integrating sphere. The results were obtained by measuring characteristics of the respective chips mounted on an aluminum substrate using an integrating sphere. FIG. 11(A) shows measurement results at a forward current IF=500 mA, and FIG. 11(B) shows measurement results at IF=700 mA.

When the reference chips (A1 to A3) and the PhC-formed chips (B4 to B6) were compared, the LED chips according to the present embodiment obtained the same results as the measurement results using the prober shown in FIGS. 9 and 10 as compared with the reference chips.

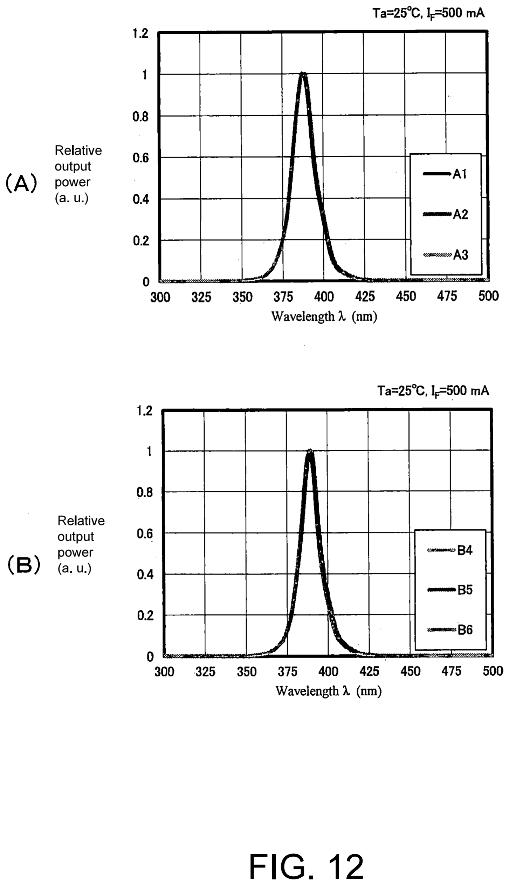

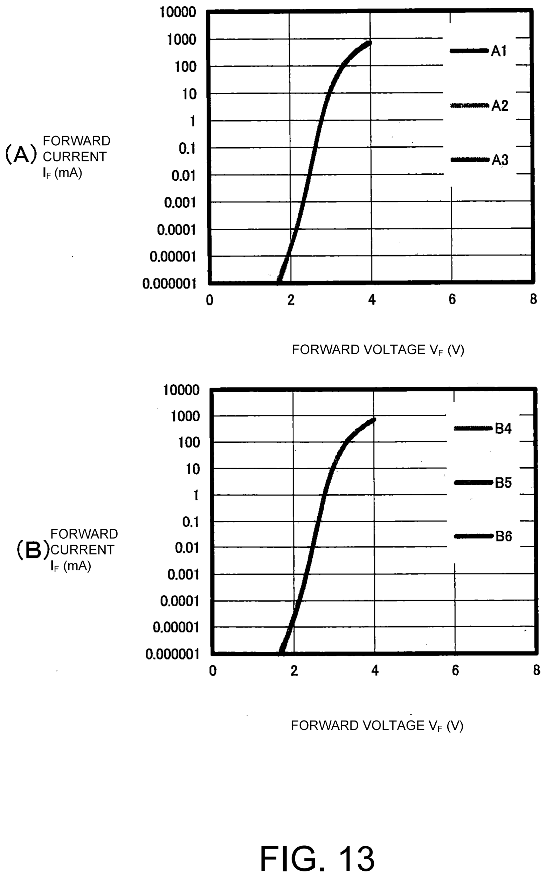

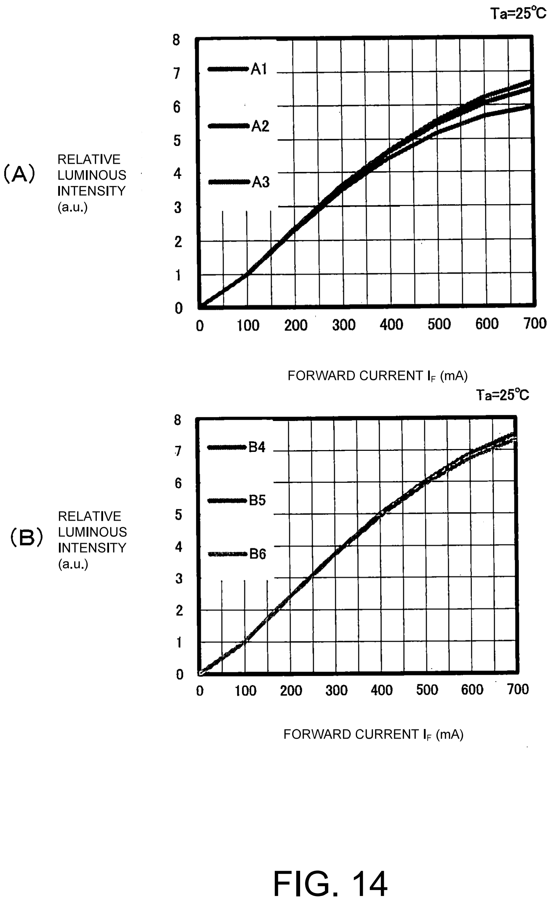

FIGS. 12, 13, and 14 show emission spectra, I-V characteristics, and I-L characteristics of the reference chips (A1 to A3) and the PhC-formed chips (B4 to B6), respectively. FIG. 12(A) shows emission spectra of the reference chips (A1 to A3), and FIG. 12(B) shows emission spectra of the PhC-formed chips (B4 to B6). The same applies to FIGS. 13 and 14. The I-L characteristics of FIG. 14 are plotted in a graph with the intensity at IF (100 mA) set to 1.

As shown in FIG. 12, the emission spectra are substantially similar between the references and PhC-formed chips. In addition, as shown in FIG. 13, the I-V characteristics are good in both the references and the PhC-formed chips.

On the other hand, as shown in FIG. 14, regarding the I-L characteristics, the decrease in output when the current increased was suppressed in the PhC-formed chips as compared with the references. This is thought to be because heat generation is small due to improvement in external quantum efficiency (EQE).

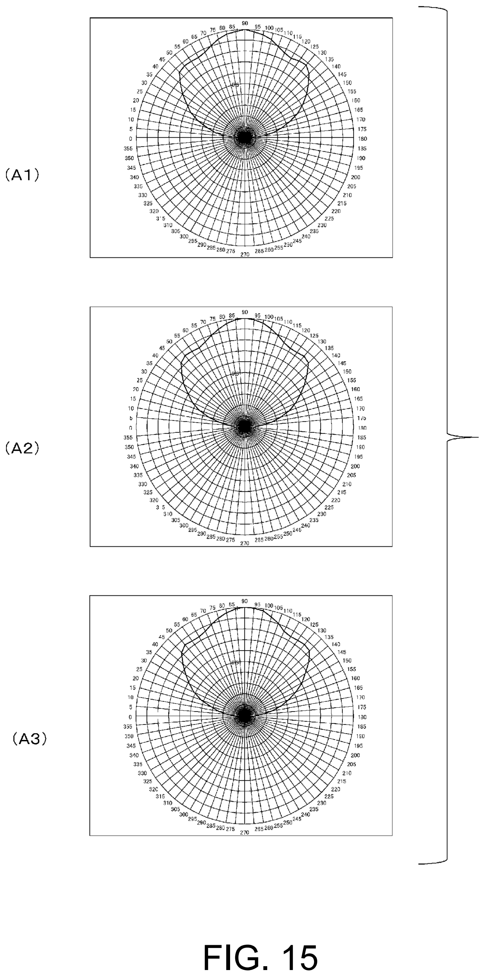

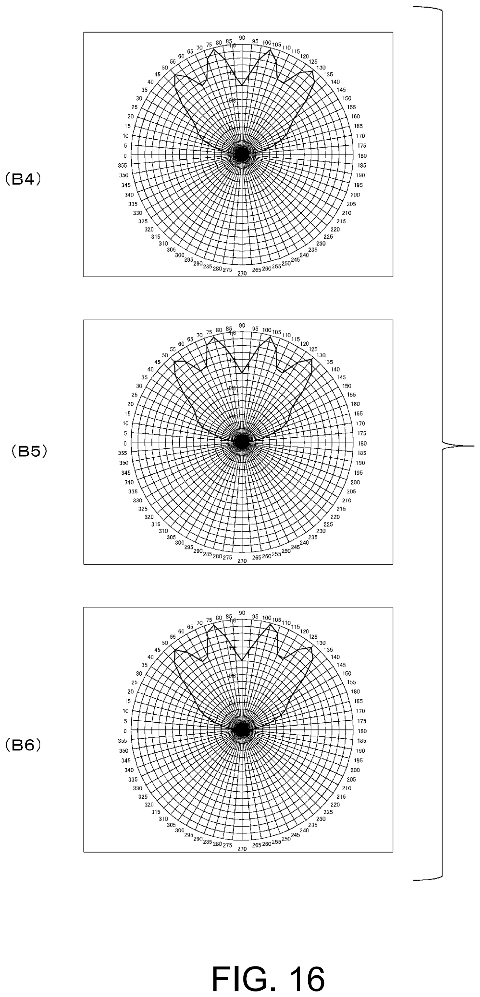

FIGS. 15 and 16 show results of measuring radiation pattern characteristics of the reference chips (A1 to A3) and the PhC-formed chips (B4 to B6), respectively. It has been confirmed that the chips have radiation pattern characteristics, and it has been observed that the PhC-formed chips according to the present embodiment tend to have increased intensities that are dispersed in four directions.

As described above, according to the present embodiment, it is possible to produce a photonic crystal by forming holes on the order of several hundred nanometers at a pitch of several hundred nanometers on the surface of the GaN layer grown on the sapphire substrate. As a result, it is possible to provide a radiation pattern characteristics by the LED chip alone without using a lens, thereby eliminating the need for making a mold, and reducing the cost. In addition, the light emission efficiency of the LED chip can be increased twice or more as compared with that in a case where no photonic crystal is formed, and the decrease in output when the current increases can be suppressed, making it possible to flexibly cope with specification changes.

### REFERENCE SIGNS LIST

- 10: sapphire substrate
- 12: n-GaN layer
- 14: MQW layer
- 16: p-GaN layer
- 18: p-electrode and reflection film
- 20: metal substrate
- 22: support substrate
- 24: n-electrode

## Claims

1. A method for manufacturing a photonic crystal gallium nitride light-emitting element, the method comprising:
forming an epitaxial structure by epitaxially growing an n-type gallium nitride layer, a multiple quantum well layer, and a p-type gallium nitride layer sequentially on a sapphire substrate;
forming a p-type electrode on the p-type gallium nitride layer;
forming a metal substrate and a support substrate on the p-type electrode;
inverting the epitaxial structure upside down so that the support substrate is located at the bottom and the sapphire substrate is located at the top;
exposing a surface of the n-type gallium nitride layer by peeling off the sapphire substrate located at the top by the inversion;
adjusting a film thickness by etching the exposed surface of the n-type gallium nitride layer;
forming a photonic crystal on the etched surface of the n-type gallium nitride layer using electron beam lithography and inductively coupled plasma reactive ion etching;
forming an n-type electrode on the n-type gallium nitride layer; and
peeling off the support substrate.

2. The method according to claim 1, wherein
the step of forming of the photonic crystal includes:
performing a hydrophobizing treatment on the surface of the n-type gallium nitride layer;
applying a resist to the surface of the n-type gallium nitride layer;
irradiating the resist with an electron beam for lithography; and
removing the resist using chlorine gas by inductively coupled plasma reactive ion etching.

3. The method according to claim 1, further comprising:
before growing the n-type gallium nitride layer on the sapphire substrate, growing a buffer layer and an undoped gallium nitride layer sequentially on the sapphire substrate.

4. The method according to any one of claims 1 to 3, wherein the photonic crystal gallium nitride light-emitting element has an emission wavelength of 380 nm to 390 nm.

5. A lighting device comprising:
the photonic crystal gallium nitride light-emitting element manufactured by the method according to any one of claims 1 to 3; and
an illumination optical system that illuminates an object with light from the photonic crystal gallium nitride light-emitting element.
